Europäisches Patentamt

European Patent Office

Office européen des brevets

(19)

(11)  **EP 0 818 819 A1**

(12)  **EUROPEAN PATENT APPLICATION**

(43) Date of publication:
14.01.1998  Bulletin 1998/03

(51) Int. Cl.⁶: **H01L 21/8238**,  H01L 27/092

(21) Application number: 97111833.6

(22) Date of filing: 11.07.1997

(84) Designated Contracting States:
AT BE CH DE DK ES FI FR GB GR IE IT LI LU MC
NL PT SE
Designated Extension States:
AL LT LV RO SI

(30) Priority: 12.07.1996 US 21679 P

(71) Applicant:
TEXAS INSTRUMENTS INCORPORATED
Dallas Texas 75265 (US)

(72) Inventor: Baumann, Robert C.
Ibaraki-Ken 305 (JP)

(74) Representative:
Schwepfinger, Karl-Heinz, Dipl.-Ing.
Prinz & Partner,
Manzingerweg 7
81241 München (DE)

(54)  **Improvements in or relating to semiconductor devices**

(57)    A method for making a CMOS device includes: forming a PMOS region 60 of a first conductivity type; forming an NMOS region 62 of a second conductivity type adjacent the PMOS region 60; forming an insulating layer 64 and 66 over the PMOS region 60 and the NMOS region 62 such that the insulating layer is thinner over the PMOS region than over the NMOS region; forming a common gate 48 over the insulating layer 64 and 66; forming PMOS source/drain regions 40 and 42 of the second conductivity type in the PMOS region 60 and aligned to the common gate 48; and forming NMOS source/drain regions 44 and 46 of the first conductivity type in the NMOS region 62 and aligned to the common gate 48.

Figure 2

Printed by Xerox (UK) Business Services
2.15.8/3.4

## Description

FIELD OF THE INVENTION

This invention generally relates to semiconductor devices. More specifically, the invention relates to CMOS transistors with a split gate oxide.

BACKGROUND OF THE INVENTION

Most of the devices used in today's electronic components are based on Complementary Metal Oxide Semiconductor (CMOS) technology. The base building block of all digital CMOS circuits combines a PMOS and NMOS transistor to form an inverter. The CMOS circuit inverts the incoming signal with the complementary action of the NMOS and PMOS transistors. One issue with all CMOS circuits is the fact that the drive capability of the PMOS is several times lower than that of the NMOS device of the same geometry. This effect is due to the fact that the majority carriers in PMOS devices are holes which have lower mobility than electrons.

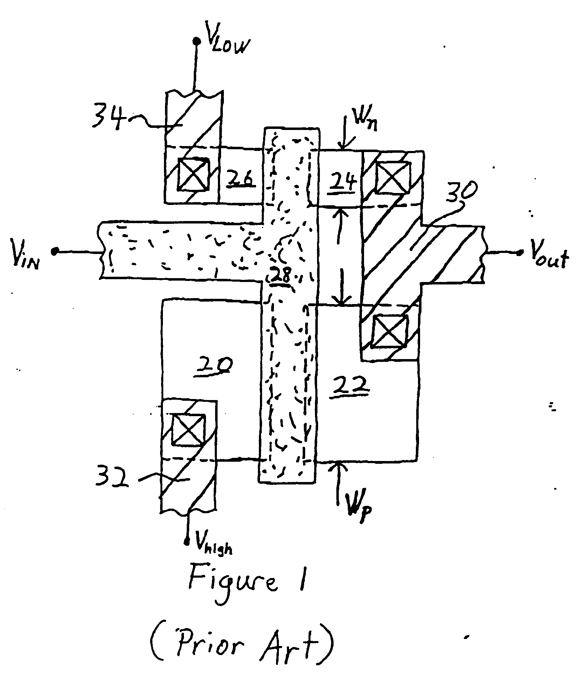

The most common solution to the asymmetry in PMOS and NMOS drive currents is to design the PMOS devices with wider gates to allow more drive current for a given gate voltage. This simple solution allows balancing of the NMOS and PMOS characteristics but at the expense of silicon area. In typical implementations a balanced CMOS arrangement would be a PMOS with a gate width two to three times larger than that of the NMOS device, as shown by the prior art device in Figure 1.

The prior art CMOS inverter layout, shown in Figure 1, includes source and drain regions 20 and 22 for the PMOS transistor, source and drain regions 24 and 26 for the NMOS transistor, common gate 28, conductive lines 30, 32, and 34, input voltage $V_{in}$, output voltage $V_{out}$, and reference voltages $V_{high}$ and $V_{low}$. The common gate 28 of the NMOS and PMOS serves as the input. The source region 24 of the NMOS and the drain region 22 of the PMOS are tied together by conductive line 30 which serves as the inverter output. Finally, conductive line 32 connects the source region 20 of the PMOS transistor to voltage reference $V_{high}$, and conductive line 34 connects the drain region 26 of the NMOS transistor to voltage reference $V_{low}$. In the prior art device of Figure 1, the PMOS width $W_p$ is approximately 2.5 times the NMOS width $W_n$.

SUMMARY OF THE INVENTION

Accordingly, the present invention provides a method for fabricating a CMOS device comprising, forming a first region and a second region of semiconductor material, treating at least a portion of the surface of the second region to inhibit the growth of an insulating material thereon, forming an insulating layer from said insulating material over the first region and the second region such that the insulating layer is thinner in the region substantially overlying the second region than in the region substantially overlying the first region, forming a gate region over the insulating layer.

BRIEF DESCRIPTION OF THE DRAWINGS

The present invention will now be further described, by way of example, with reference to the accompanying drawings in which:

FIG. 1 is a plan view of a prior art CMOS device;

FIG. 2 is a plan view of a preferred embodiment split gate oxide CMOS device;

FIG. 3 is cross-sectional diagram of the device of FIG. 2;

FIGS. 4 and 5 are cross-sectional views showing the device of FIG. 3 at two stages of fabrication;

FIG. 6 is a cross-sectional diagram of the device of FIG. 2 showing the source/drain regions of the PMOS device;

FIG. 7 is a cross-sectional diagram of the device of FIG. 2 showing the source/drain regions of the NMOS device; and

Corresponding numerals and symbols in the different figures refer to corresponding parts unless otherwise indicated.

DETAILED DESCRIPTION OF PREFERRED EMBODIMENTS

By using two different gate oxide (insulator) thicknesses for the PMOS and NMOS transistors, a greatly reduced cell size is achieved in CMOS devices. This approach works because the drive current of NMOS and PMOS field effect transistors is a function of:

$$I_d \gg W + C_i = W + (M_i/d)$$

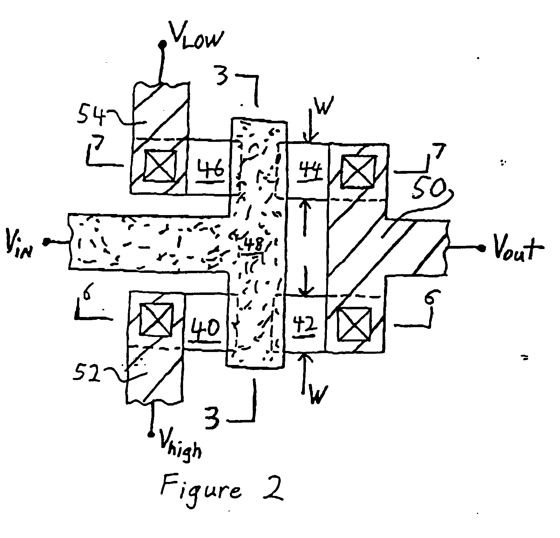

Where $I_d$ is the drive current, W is the gate width, and d is the gate insulator thickness. As shown by the above equation, the drive current increases linearly with increases in gate width and decreases in gate thickness. A process which can allow PMOS gate oxides to be thinner has a similar effect on increasing drive current as a design which increases the PMOS gate width. By controlling the gate insulator thickness, an inverter circuit layout with identical gate widths for the PMOS and NMOS devices is provided, as shown in Figure 2. This layout is achieved with a PMOS having a gate insulator which is roughly half as thick as the NMOS transistor gate insulator.

Figure 2 is a plan view of a preferred embodiment split gate oxide CMOS device. The device of Figure 2 includes source and drain regions 40 and 42 for the PMOS transistor, source and drain regions 44 and 46 for the NMOS transistor, common gate 48 which serves as the PMOS gate and the NMOS gate, conductive lines 50, 52, and 54, input voltage $V_{in}$, output voltage $V_{out}$, and reference voltages $V_{high}$ and $V_{low}$. The common gate 48 of the NMOS and PMOS serves as the input. The source 44 of the NMOS and the drain 42 of the PMOS are tied together by conductive line 50 which serves as the inverter output. Conductive line 52 connects the source 40 of the PMOS transistor to voltage reference $V_{high}$, and conductive line 54 connects the drain 46 of the NMOS transistor to voltage reference $V_{low}$. In the preferred embodiment of Figure 2, the PMOS and NMOS have the same width W.

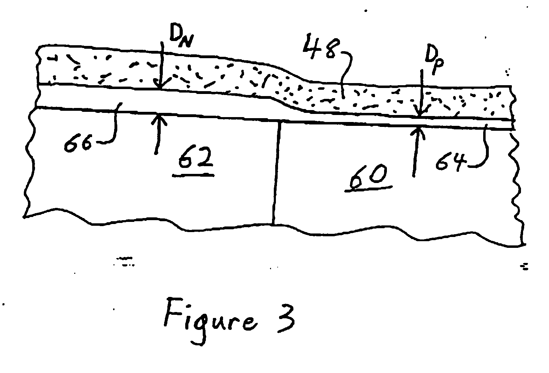

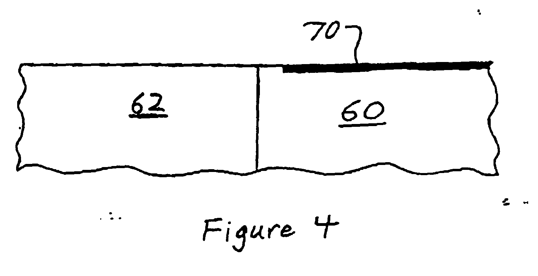

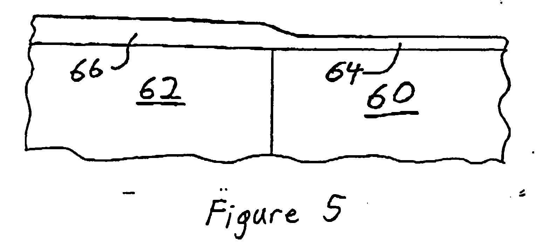

Figure 3 is cross-sectional diagram of the device of Figure 2. Figure 3 includes common gate 48, N type PMOS region 60, P type NMOS region 62, PMOS oxide region 64 (PMOS insulator), NMOS oxide region 66 (NMOS insulator), PMOS oxide thickness $D_P$, and NMOS oxide thickness $D_N$. In the preferred embodiment, the PMOS oxide thickness $D_P$ is about half the NMOS oxide thickness $D_N$. Figures 4 and 5, show the device of Figure 3 at two stages of fabrication.

One simple way to create the split gate oxide is to implant or surface treat the PMOS gate surfaces prior to oxidation with a substance such as nitrogen. Nitrogen impedes the growth of oxides by altering the surface reaction rates. A process which introduces nitrogen at the PMOS gate silicon is therefore the preferred method of assuring that the PMOS gate oxides will be thinner than their NMOS counter parts for the same oxidation process. B. Doyle et al., "Simultaneous Growth of Different Thickness Gate Oxides in Silicon CMOS Processing", IEEE Elec. Dev. Lett., V16.7, 1995, discloses such an impact on gate oxides, and reports that implanted nitrogen can suppress growth rates by at least a factor of two. The use of nitrogen implantation also avoids the extra process steps and negative yield impact of other split gate technologies.

Referring to Figures 4 and 5, a method of forming the preferred embodiment of Figure 3 is described in detail. Figure 4 illustrates the P type PMOS region 60 and the N type NMOS region 62. The surface is patterned and nitrogen is implanted followed by an anneal to form nitrogen implant region 70, shown in Figure 4. Next, oxide regions 64 and 66 are grown, as shown in Figure 5. Then epitaxial layer (common gate) 48 is formed over oxide regions 64 and 66, as shown in Figure 3.

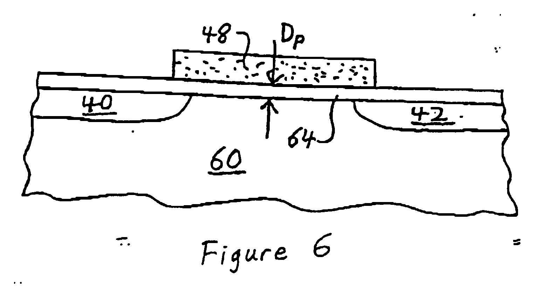

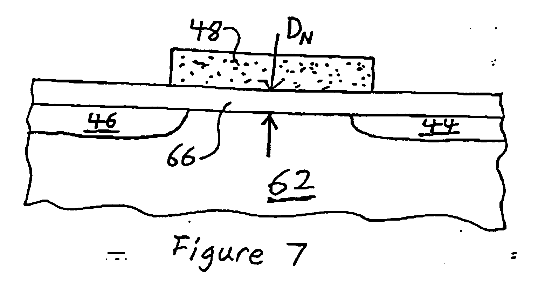

The source/drain regions 40, 42, 44, and 46, shown in Figures 6 and 7, are then formed by methods well known in the art. Figure 6 is a cross section of the source/drain regions of the PMOS transistor. Figure 6 includes P type PMOS source 40, P type PMOS drain 42, N type region 60, PMOS oxide region 64, common gate 48 (PMOS gate), and PMOS oxide thickness $D_P$. Figure 7 is a cross section of the source/drain regions of the NMOS transistor. Figure 7 includes N type NMOS source 44, N type NMOS drain 46, P type region 62, NMOS oxide region 66, cowon gate 48 (NMOS gate), and NMOS oxide thickness $D_N$.

The preferred embodiment split gate oxide CMOS device provides the advantage of reduced chip area for CMOS devices including circuits with repetitive CMOS components such as SRAM and DRAM devices.

A preferred embodiment has been described in detail hereinabove. It is to be understood that the scope of the invention also comprehends embodiments different from those described, yet within the scope of the claims.

For example, a process which increases the growth rate of the NMOS gate oxide could be used instead of a process which reduces the growth rate of the PMOS oxide. Also, combinations of these two processes could be used to obtain the optimum oxide growth rates.

While this invention has been described with reference to an illustrative embodiment, this description is not intended to be construed in a limiting sense. Various modifications and combinations of the illustrative embodiment, as well as other embodiments of the invention, will be apparent to persons skilled in the art upon reference to the description.

## Claims

1. A method for fabricating a CMOS device comprising;

   forming a first region and a second region of semiconductor material;
   treating at least a portion of the surface of the second region to inhibit the growth of an insulating material thereon;
   forming an insulating layer from said insulating material over the first region and the second region such that the insulating layer is thinner in the region substantially overlying the second region than in the region substantially overlying the first region;
   forming a gate region over the insulating layer.

2. The method as claimed in Claim 1, wherein the step of forming the first region and the second region comprises forming an NMOS region and a PMOS region respectively.

3. The method as claimed in Claim 1 or Claim 2, wherein the step of treating the surface of the second region comprises exposing the surface of the second region to nitrogen.

4. The method as claimed in any preceding claim, wherein the step of forming the first region and the second region comprises forming the first region and the second region from material having a first conductivity type and a second conductivity type respectively.

5. The method as claimed in any preceding claim, wherein the step of forming the insulating layer comprises forming a first insulating region substantially over the first region, and forming a second insulating layer substantially over the second region.

6. The method as claimed in Claim 5, wherein the step of forming the first insulating region and the second insulating region comprises forming a first oxide region and a second oxide region respectively.

7. The method as claimed in any preceding claim, wherein the step of forming the gate region comprises forming a first gate region on the first insulating region and a second gate region on the second insulating region.

8. The method as claimed in any preceding claim further comprising;

forming the first region substantially adjacent to the second region.

9. The method as claimed in any preceding claim further comprising;

forming first current guiding regions in the first region and second current guiding regions in the second region.

10. The method as claimed in Claim 9, wherein the step of forming the first current guiding regions comprises forming source/drain regions of the first conductivity type.

11. The method as claimed in Claim 9 or Claim 10, wherein the step of forming the first current guiding regions comprises forming the first current guiding regions such that each of the first current guiding regions is substantially aligned to the gate region.

12. The method as claimed in any of Claims 9 to 11, wherein the step of forming the second current guiding regions comprises forming source/drain regions of the second conductivity type.

13. The method as claimed in any of Claims 9 to 12, wherein the step of forming the second current guiding regions comprises forming the second current guiding regions such that each of the second current guiding regions is substantially aligned to the gate region.

14. The method as claimed in any preceding claim, wherein the step of forming the insulating layer comprises forming the insulating layer such that the thickness over the treated portion is less than two-thirds the thickness over the first region.

15. The method as claimed in any of Claims 12 to 14 further comprising;

forming a conductive line coupled to the drain region of the first region and the source region of the second region.

16. The method as claimed in any preceding claim, wherein the step of treating the surface of the second region comprises implanting nitrogen into the surface of the second region.

17. A CMOS device fabricated according to the method of any of Claims 1 to 16.

18. A CMOS device comprising;

a PMOS region and an NMOS region;
a gate region overlying the NMOS region and the PMOS region;
a first oxide region formed between the gate region and the NMOS region; and
a second oxide region formed between the gate region and the PMOS region such that the second oxide region is thinner than the first oxide region.

Figure 1

( Prior Art )

Figure 2

Figure 3

Figure 4

Figure 5

Figure 6

Figure 7

# DOCUMENTS CONSIDERED TO BE RELEVANT

**European Patent Office**

**EUROPEAN SEARCH REPORT**

Application Number

EP 97 11 1833

| Category | Citation of document with indication, where appropriate, of relevant passages | Relevant to claim | CLASSIFICATION OF THE APPLICATION (Int.Cl.6) |
|---|---|---|---|
| X | US 4 866 002 A (SHIZUKUISHI MAKOTO ET AL) <br><br> * abstract; claims 1,2,4; figures 2,4,5 * <br> * column 2, line 48 - line 60 * <br> * column 4, line 50 - line 55 * <br> * column 5, line 45 - line 66 * | 1,2,<br>4-14,17,<br>18 | H01L21/8238<br>H01L27/092 |
| Y | | 1-14,<br>16-18 | |
| Y | US 5 330 920 A (SOLEIMANI HAMID R ET AL) <br><br> * abstract; claims 1-6; figures 1-6 * | 1-14,<br>16-18 | |
| X | PATENT ABSTRACTS OF JAPAN <br> vol. 013, no. 270 (E-776), 21 June 1989 <br> & JP 01 061048 A (NEC CORP), 8 March 1989, <br> * abstract * | 1,2,<br>4-13,17,<br>18 | |
| X | PATENT ABSTRACTS OF JAPAN <br> vol. 014, no. 108 (E-0896), 27 February 1990 <br> & JP 01 309367 A (FUJITSU LTD), 13 December 1989, <br> * abstract * | 18 | TECHNICAL FIELDS SEARCHED (Int.Cl.6) <br><br> H01L |
| A | | 1,2,<br>4-13,17 | |
| X | PATENT ABSTRACTS OF JAPAN <br> vol. 011, no. 217 (E-523), 14 July 1987 <br> & JP 62 037959 A (SONY CORP), 18 February 1987, <br> * abstract * | 18 | |
| A | | 1,2,<br>4-13,17 | |
|  | -/-- | | |

The present search report has been drawn up for all claims

| Place of search | Date of completion of the search | Examiner |
|---|---|---|
| THE HAGUE | 24 October 1997 | Wirner, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

**EUROPEAN SEARCH REPORT**

Application Number

EP 97 11 1833

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | PATENT ABSTRACTS OF JAPAN vol. 007, no. 140 (E-182), 18 June 1983 & JP 58 054638 A (MITSUBISHI DENKI KK), 31 March 1983, * abstract * | 1,3,16 | |
| A | EP 0 324 459 A (FUJITSU LTD) * abstract; claim 1; figures * | 1,9-13, 15 | |
| P,X | PATENT ABSTRACTS OF JAPAN vol. 097, no. 008, 29 August 1997 & JP 09 092729 A (MITSUBISHI ELECTRIC CORP), 4 April 1997, * abstract * | 1-13, 16-18 | |

TECHNICAL FIELDS SEARCHED (Int.Cl.6)

The present search report has been drawn up for all claims

| Place of search | Date of completion of the search | Examiner |
|---|---|---|
| THE HAGUE | 24 October 1997 | Wirner, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)